# EUROPÄISCHE PATENTANMELDUNG

(11) **EP 1 125 669 A2**
(43) Veröffentlichungstag der Anmeldung: **22.08.2001**
(21) Anmeldenummer: 01250048.4
(22) Anmeldetag: 10.02.2001
(51) Int. Cl.: B23K 3/06

(54) **Verfahren und Vorrichtung zum Verfüllen von Kavitäten**

(30) Priorität: 15.02.2000 DE 10008031
(71) Anmelder: BOS Berlin Oberspree Sondermaschinenbau, 12459 Berlin (DE)
(72) Erfinder: Butzke, Günter, 12557 Berlin (DE); Schimko, Richard, 12623 Berlin (DE); Römer, Siegfried, 16562 Bergfelde (DE); Muschick, Jürgen, 10243 Berlin (DE); Edling, Karsten, 12459 Berlin (DE)
(74) Vertreter: Eisenführ, Speiser & Partner

(57) **Zusammenfassung**

Verfahren zum Verfüllen von im Submillimeterbereich liegenden Kavitäten in einem Bauteil (3), insbesondere einer Leiterplatte, mit einem Verfüllwerkstoff, bei dem das Bauteil (3) in ein Bad (2) des Verfüllwerkstoffs eingetaucht wird und die Kavitäten infolge des im Bad (2) bei der Eintauchtiefe vorherrschenden Drucks mit dem Verfüllwerkstoff ausgefüllt werden, wobei der im Bad (2) vorherrschende Druck zur Reduktion der zum Verfüllen der Kavitäten erforderlichen Eintauchtiefe erhöht wird. Vorrichtung zur Durchführung des Verfahrens.

## Beschreibung

Die Erfindung betrifft ein Verfahren zum Verfüllen von im Submillimeterbereich liegenden Kavitäten in einem Bauteil, insbesondere einer Leiterplatte, mit einem Verfüllwerkstoff, bei dem das Bauteil in ein Bad des Verfüllwerkstoffs eingetaucht wird und die Kavitäten infolge des im Bad bei der Eintauchtiefe vorherrschenden Drucks mit dem Verfüllwerkstoff ausgefüllt werden sowie eine Vorrichtung zum Verfüllen von im Submillimeterbereich liegenden Kavitäten in einem Bauteil, insbesondere einer Leiterplatte, mit einem Verfüllwerkstoff, umfassend ein Bad des Verfüllwerkstoffs zum Verfüllen der Kavitäten mit dem Verfüllwerkstoff durch Eintauchen des Bauteils in das Bad.

Aus der DE 198 23 447 A1 ist ein solches Verfahren zum Verfüllen von im Submillimeterbereich liegenden Kavitäten in einer Leiterplatte mit einem Lotwerkstoff sowie eine entsprechende hierzu dienende Vorrichtung bekannt. Sie finden beispielsweise im Zusammenhang mit der Bestückung und Kontaktierung von Leiterplatten mit elektronischen Bauelementen ihre Anwendung. Derartige Leiterplatten tragen ein, beispielsweise durch photochemisches Beschichten erzeugtes, Leitungsschema mit sacklochartigen Kavitäten für den elektrischen Anschluß miniaturisierter elektronischen Bauelemente. Um die Kontaktierung dieser elektronischen Bauelemente mit einfachen technologischen Mitteln kostengünstig vornehmen zu können, ist ein vorheriges Verfüllen der Kavitäten mit einem Lotwerkstoff erforderlich.

Bei dem genannten Verfahren wird die Leiterplatte hierzu in ein Lotbad eingetaucht. Die Kavitäten werden dann infolge des im Bad bei einer bestimmten Eintauchtiefe vorherrschenden statischen Drucks unter Überwindung der Oberflächenspannung des Lots mit dem Lot ausgefüllt. Anschließend werden die Leiterplatten mittels des auf sie einwirkenden Auftriebs in einem engen Kanal im Tauchbad zur Badoberfläche gefördert und von dieser dann durch entsprechende Fördereinrichtungen aus dem Bad entfernt.

Die zum Verfüllen der Kavitäten mindestens erforderliche Eintauchtiefe bestimmt sich nach den Abmessungen der Kavitäten, nach der Oberflächenspannung des geschmolzenen, das Tauchbad bildenden Lotwerkstoffs und nach dessen spezifischem Gewicht. Je kleiner die Kavitäten und je größer die Oberflächenspannung des geschmolzenen Lotwerkstoffs desto größer ist der zu Verfüllen erforderliche Druck und damit die Mindesteintauchtiefe.

Das bekannte Verfahren weist den Nachteil auf, dass sich aufgrund dieses Zusammenhangs relativ große Eintauchtiefen und damit lange Verweilzeiten der Leiterplatte im Lotbad ergeben. Lange Verweilzeiten im Lotbad sind jedoch unter Qualitätsgesichtspunkten unerwünscht. So kann es infolge der erforderlichen hohen Badtemperaturen bei langer Verweilzeit zu einer thermischen Beschädigung von Teilen der Leiterplatte, beispielsweise aufgebrachter Lackschichten etc., kommen. Ein weiteres Problem ist die mögliche Freisetzung von Residualspannungen in der Leiterplatte bei diesen erhöhten Temperaturen, die zum Verzug der Leiterplatte führen kann. Aufgrund der für derartige elektronische Bauteile einzuhaltenden sehr engen Maßtoleranzen ist ein solcher Verlust der Maßhaltigkeit in jedem Fall zu vermeiden.

Der Erfindung liegt deshalb die Aufgabe zugrunde, ein Verfahren der eingangs genannten Art zur Verfügung zu stellen, das ein möglichst gutes, schnelles und damit schadensfreies Verfüllen der Kavitäten sicherstellt. Ebenso ist es Aufgabe der Erfindung, eine Vorrichtung zur Durchführung eines solchen Verfahrens anzugeben.

Die Aufgabe wird, ausgehend von einem Verfahren gemäß dem Oberbegriff des Anspruchs 1, durch die im kennzeichnenden Teil des Anspruchs 1 angegebenen Merkmale gelöst. Weiterhin wird sie, ausgehend von einer Vorrichtung gemäß dem Oberbegriff des Anspruchs 13, durch die im kennzeichnenden Teil des Anspruchs 13 angegebenen Merkmale gelöst

Die Erfindung beruht auf der Erkenntnis, dass die Verweilzeiten der Bauteile im Bad erheblich reduziert werden können, wenn der im Bad vorherrschende Druck zur Reduktion der zum Verfüllen der Kavitäten erforderlichen Eintauchtiefe erhöht wird.

Die Erfindung kann sowohl in einer kontinuierlichen Arbeitsweise, d. h. mit stets gleichbleibendem erhöhten Druck im Bad, als auch bei einer zyklischen Arbeitsweise angewendet werden, bei der mit jedem zu behandelnden Bauteil bzw. jeder im wesentlichen gleichzeitig zu behandelnden Anzahl von Bauteilen ein Zyklus aus Druckanstieg und Druckabfall durchfahren wird.

Die Druckerhöhung kann bei zyklischer Arbeitsweise dadurch erfolgen, dass das Volumen des dann abgeschlossenen Raumes über dem Bad durch Anheben des Badpegels verringert wird, wodurch die darin befindliche Gasatmosphäre komprimiert wird. Dieses Anheben des Badpegels kann durch auf das Bad einwirkende Verdrängereinrichtungen, wie z. B. Kolben, erfolgen. Es kann aber auch durch Verbinden des Bades mit einem Reservoir erfolgen, in dem sich flüssiger Verfüllwerkstoff mit einem entsprechend höheren Pegelstand befindet. Das Eintauchen des Bauteils mit den zu verfüllenden Kavitäten kann dann auch zumindest teilweise durch das Anheben des Badpegels realisiert sein. Auch hier lassen sich bei entsprechend dimensionierten Durchflußquerschnitten kurze Verweilzeiten im Bad realisieren.

Vorzugsweise erfolgt die Druckerhöhung im Bad bei kontinuierlicher oder zyklischer Arbeitsweise durch unmittelbare Einwirkung auf die Atmosphäre über dem Bad bei im wesentlichen konstantem Pegel des Bades. Dies kann beispielsweise durch Einwirken entsprechender Pumpen etc. erfolgen.

Weiter vorzugsweise erfolgt die Druckerhöhung durch Verbinden des Raumes über dem Bad mit einem Überdruckreservoir, das ein Gas oder Gasgemisch mit entsprechend hohem Überdruck enthält. Hierdurch lassen sich besonders schnelle Druckanstiege im Bad erzielen, die mit Blick auf die möglichst kurzen Verweilzeiten insbesondere dann von Vorteil sind, wenn der Druckanstieg erst bei schon eingetauchtem Bauteil erfolgen soll.

Um möglichst kurze Verweilzeiten und hohen Durchsatz zu realisieren, erfolgt die Druckerhöhung bevorzugt schlagartig, da dann höchstens geringe Zeitverluste durch die Druckerhöhung anfallen.

Bei bevorzugten Varianten des erfindungsgemäßen Verfahrens wird zur Verhinderung von Verunreinigungen des Bades an der Grenzfläche zum Bad wenigstens eine Schicht eines Gases oder Gasgemisches etabliert. Das Gas oder Gasgemisch ist dabei zur Verhinderung von Verunreinigungen des Bades bewirkenden Reaktionen ausgebildet. Solche Verunreinigungen ergeben sich beispielsweise bei einem Bad aus herkömmlichem Lötzinn durch die Oxidationsreaktion des Lötzinns mit Luftsauerstoff. Sie werden häufig als sog. "Zinnkrätze" bezeichnet.

Solche Verunreinigungen können sich an den zu bearbeitenden Bauteilen oder an Fördereinrichtungen wie Walzen etc. ablagern und aufgrund ihrer Härte zu Beschädigungen der zu bearbeitenden Bauteile etc. führen. Die erfindungsgemäße Gasschutzschicht über dem Bad verhindert solche Verunreinigungen und stellt somit eine hohe Qualität des Bearbeitungsergebnisses sicher.

Das Etablieren einer solchen Schicht aus einem Verunreinigungsreaktionen verhindernden Gas oder Gasgemisch über dem Bad aus dem Verfüllwerkstoff stellt im übrigen einen eigenständigen Erfindungsgedanken dar.

Bei vorteilhaften Varianten des erfindungsgemäßen Verfahrens ist die Schicht aus dem Gas oder Gasgemisch als im wesentlichen inerte Sperrschicht ausgebildet ist. Sie verhindert, dass die mit dem Bad zu solchen Verunreinigungsreaktionen führende Atmosphäre über dem Bad, wie z.B. Luftsauerstoff, mit dem Bad in Kontakt kommt. Ihre Ausbildung als inerte Schicht verhindert Verunreinigungsreaktionen. Bei dem Gas bzw. Gasgemisch kann es sich dabei um ein Inertgas handeln, beispielsweise ein Edelgas. Dem erfindungsgemäßen Zweck genügt jedoch auch ein Gas bzw. Gasgemisch, das im wesentlichen keine Verunreinigungen bildenden Reaktionen mit dem flüssigen Verfüllwerkstoff eingeht.

Bei anderen bevorzugten Varianten des Verfahrens ist die Schicht aus dem Gas oder Gasgemisch derart ausgebildet, dass sich Verunreinigungen des Bades bewirkende erste Reaktionen und diese ersten Reaktionen rückgängig machende zweite Reaktionen im wesentlichen die Waage halten. Bei diesen Ausführungen kommt die übrige Atmosphäre über dem Bad zwar mit dem Bad in Kontakt, wobei es zu entsprechenden ersten Verunreinigungsreaktionen kommt, diese werden aber aufgrund der Anwesenheit des Gases bzw. Gasgemischs umgehend durch zweite Reaktionen in einem Maß rückgängig gemacht, dass sich insgesamt im wesentlichen keine Verunreinigungen bilden.

So ist das Gas bzw. Gasgemisch beispielsweise insbesondere so ausgebildet, dass sich Oxidation des Verfüllwerkstoffs an der Badoberfläche und die Reduktion des so oxidierten Badanteils im wesentlichen die Waage halten. Hierbei enthält Gas oder Gasgemisch vorzugsweise einen für die Reduktion ausreichenden Anteil Wasserstoff. Beispielsweise kann es sich hierbei um eine Zusammensetzung aus Stickstoff und Wasserstoff handeln.

Bei einer bevorzugten Ausführung des erfindungsgemäßen Verfahrens wird der Raum über dem Bad in einem Spülschritt vor dem Eintauchen des Bauteils in das Bad mit dem Gas oder Gasgemisch gespült. Hierdurch wird verhindert, dass es beim Eintauchen zu einem Kontakt zwischen der zu Verunreinigungen führenden Atmosphäre über der Schicht aus dem Gas bzw. Gasgemisch kommt. Es versteht sich jedoch, dass dieser Spülschritt entfallen kann, wenn bei anderen Varianten des erfindungsgemäßen Verfahrens das Gas bzw. Gasgemisch den Raum die Atmosphäre im Raum über dem Bad bilden.

Die Schicht aus dem Gas bzw. Gasgemisch kann in vielfacher Weise angrenzend an die Badoberfläche etabliert werden. Sie kann schon allein aufgrund des Dichteunterschiedes zur übrigen Atmosphäre im Raum über dem Bad bestehen. Auch ist es möglich, sie durch entsprechende Zirkulationseinrichtungen, beispielsweise geeignete Ausblas- und Absaugeinrichtungen, über der Badoberfläche aufrecht zu erhalten.

Bei besonders einfachen Verfahrensvarianten ist die Schicht aus dem Gas oder Gasgemisch vom übrigen Raum über dem Bad vor dem Eintauchen des Bauteils durch eine Trenneinrichtung abgetrennt, beispielsweise durch einen oder mehrere Trennschieber. Die Trenneinrichtung wird dann zum Eintauchen der Bauteile entfernt. Bei Varianten mit einem Spülschritt erfolgt dies vorzugsweise erst nach dem Spülschritt.

Die vorliegende Erfindung betrifft weiterhin ein Verfahren zum Verfüllen von im Submillimeterbereich liegenden Kavitäten in einem Bauteil, insbesondere einer Leiterplatte, mit einem Verfüllwerkstoff, bei dem das Bauteil in ein Bad des Verfüllwerkstoffs eingetaucht wird und die Kavitäten infolge des im Bad bei der Eintauchtiefe vorherrschenden Drucks mitdem Verfüllwerkstoff ausgefüllt werden. Dieses zeichnet sich dadurch aus, dass der das Bauteil vor dem Eintauchen in das Bad umgebende Raum vor dem Eintauchen wenigstens bis zu einem Evakuierungsgrad evakuiert wird, der ausreicht, um die Kavitäten des Bauteils im eingetauchten Zustand bis zu einem Verfüllgrad zu verfüllen, der störende Blasen in den mit Verfüllwerkstoff ausgefüllten Kavitäten im wesentlichen ausschließt.
Hierdurch werden, insbesondere aber nicht nur in Verbindung mit den oben beschriebenen Varianten, zum einen die erforderlichen Verweilzeiten des Bauteils im Bad reduziert, da eine geringerer Druck und damit gegebenenfalls eine geringere Eintauchtiefe erforderlich ist, um den Verfüllwerkstoff gegen den Widerstand in den Kavitäten eventuell verbliebenen Gases in die Kavitäten zu drücken.
Zum anderen werden Blasen in den mit Verfüllwerkstoff ausgefüllten Kavitäten verhindert, die beim Aushärten oder beim späteren erneuten Aufschmelzen des Verfüllwerkstoffs unter normalem Umgebungsdruck unter Umständen eine störende Größe erreichen. So kann verhindert werden, dass derartige Blaseneinschlüsse eine Größe erreichen, welche die elektrischen Leiteigenschaften des Verfüllwerkstoffpfropfens in der jeweiligen Kavität nachteilig beeinflußt. Ebenso kann verhindert werden, dass derartige Blaseneinschlüsse beim Aushärten oder erneuten Aufschmelzen des Verfüllwerkstoffs unter normalem Umgebungsdruck eine übermäßige Menge an Verfüllwerkstoff wieder aus der Kavität drücken, so dass diese nicht mehr mit ausreichend Verfüllwerkstoff angefüllt ist.

Bei vorteilhaften, weil mit geringem Aufwand verbundenen Varianten des erfindungsgemäßen Verfahrens wird nicht vollständig evakuiert, sondern der Grad der Evakuierung liegt im Vorvakuum-Bereich, insbesondere im Bereich von 0,1 bar, da dies ausreichen kann, um störende Blaseneinschlüsse zu verhindern.

Die vorliegende Erfindung betrifft weiterhin eine Vorrichtung zur Durchführung des beschriebenen Verfahrens. Es handelt sich dabei um eine Vorrichtung zum Verfüllen von im Submillimeterbereich liegenden Kavitäten in einem Bauteil, insbesondere einer Leiterplatte, mit einem Verfüllwerkstoff, umfassend ein Bad des Verfüllwerkstoffs zum Verfüllen der Kavitäten mit dem Verfüllwerkstoff durch Eintauchen des Bauteils in das Bad, welche sich dadurch auszeichnet, dass zur Reduktion der zum Verfüllen der Kavitäten erforderlichen Eintauchtiefe des Bauteils eine Druckerhöhungseinrichtung zum Erhöhen des im Bad vorherrschenden Drucks vorgesehen ist.

Die Druckerhöhungseinrichtung ist bevorzugt zum Erhöhen des Drucks im Raum über dem Bad ausgebildet, wobei sie weiter vorzugsweise von einem mit dem Raum über dem Bad verbindbaren Überdruckreservoir gebildet ist.

Bei vorteilhaften Varianten ist eine erste Einrichtung zum Etablieren wenigstens einer ersten Schicht eines ersten Gases oder Gasgemisches an der Grenzfläche zum Bad vorgesehen. Diese umfaßt vorzugsweise eine Trenneinrichtung, bevorzugt wenigstens einen Sperrschieber zum Abtrennen des von der Schicht des ersten Gases oder Gasgemischs eingenommenen Raums von dem übrigen Raum über dem Bad, da hiermit ein besonders einfaches Herstellen und Aufrechterhalten der Schicht des ersten Gases oder Gasgemischs möglich ist.

Andere vorteilhafte Weiterbildungen der Erfindung sind in den Unteransprüchen gekennzeichnet bzw. werden nachstehend zusammen mit der Beschreibung der bevorzugten Ausführung der Erfindung anhand der Figur näher dargestellt. Es zeigen:

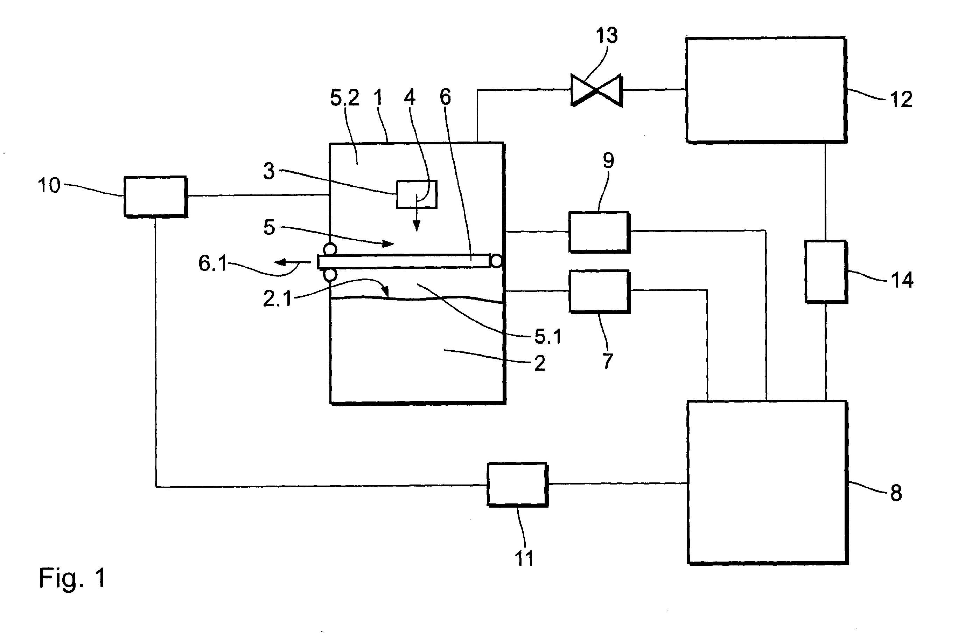

- Figur 1: eine schematisch Darstellung eines bevorzugten Ausführungsbeispiel einer erfindungsgemäßen Vorrichtung zur Durchführung einer Variante des erfindungsgemäßen Verfahrens.

Figur 1 zeigt eine Vorrichtung zur Durchführung einer Variante des erfindungsgemäßen Verfahrens mit einer abgeschlossenen Kammer 1, in der sich ein Bad 2 aus einem Verfüllwerkstoff befindet. Im gezeigten Beispiel handelt es sich bei dem Bad 2 um ein Schmelzbad aus einem Zinnlot.

In der Kammer 1 befindet sich ein Bauteil 3, das durch eine nicht dargestellte Zufuhreinrichtung in die Kammer 1 verbracht wurde. Bei dem Bauteil handelt es sich um eine Leiterplatte 3 mit einer oder mehreren Kavitäten im Submillimeterbereich, die mit dem Lot verfüllt werden sollen. Dies geschieht, indem die Leiterplatte 3 mittels einer nicht dargestellten Taucheinrichtung in Richtung des Pfeiles 4 in das Bad 2 getaucht wird. Der in einer bestimmten Eintauchtiefe vorherrschende Druck im Bad 2 reicht dann aus, um das Lot gegen den Widerstand der Oberflächenspannung des Lotes und gegebenenfalls gegen den Widerstand von Gaseinschlüssen in den Kavitäten in die Kavitäten zu drücken und diese somit auszufüllen.

Die Vorrichtung weist weiterhin eine erste Einrichtung zum Etablieren einer Schicht eines ersten Gases bzw. Gasgemisches an der Grenzfläche 2.1 zum Bad 2. Die erste Einrichtung umfasst dabei einen den Raum 5 über dem Bad 2 unterteilenden Trennschieber 6 sowie eine Versorgungseinrichtung 7.

Der Trennschieber 6 ist dichtend in der Kammer 1 gelagert. Er unterteilt den Raum 5 in einen ersten Raumabschnitt 5.1 zwischen dem Trennschieber 6 und dem Bad 2 und einen zweiten Raumabschnitt 5.2 über dem Trennschieber 6, in dem sich die Leiterplatte 3 zunächst befindet.

Der erste Raumabschnitt 5.1 wird über eine Versorgungseinrichtung 7 aus einem Reservoir 8 mit einem gasförmigen Medium beschickt, das eine Verunreinigung des Bades 2 infolge einer Reaktion des Lotes mit der über dem Bad 2 befindlichen Atmosphäre verhindert. Im gezeigten Beispiel handelt es sich bei dem gasförmigen Medium um ein Inertgas, das nicht unter Bildung von Verunreinigungen des Bades 2 mit dem Lot reagiert. Dieses Inertgas bildet eine inerte Schicht an der Grenzfläche des Bades, wobei durch den geschlossenen Sperrschieber 6 sichergestellt ist, dass das Bad 2 nicht mit der Atmosphäre im zweiten in Kontakt gelangt.

Insgesamt wird dadurch eine inerte Sperrschicht an der Grenzfläche des Bades realisiert.

Der zweite Raumabschnitt 5.2 kann mittels einer Spüleinrichtung 9 mit dem Inertgas aus dem Reservoir 8 gespült werden, so dass auch im zweiten Raumabschnitt 5.2 nicht mehr die ursprüngliche Atmosphäre vorhanden ist, sondern der zweite Raumabschnitt 5.2 ebenfalls mit diesem Inertgas gefüllt ist. Danach ist es möglich, den Sperrschieber 6 in Richtung des Pfeiles 6.1 zu entfernen und die Leiterplatte 3 in Richtung des Pfeiles 4 in das Bad 2 einzutauchen, ohne dass das Risiko von Verunreinigungen des Bades 2 besteht.

Es versteht sich, dass bei anderen Varianten die erste Einrichtung zum Etablieren einer Schicht eines ersten Gases bzw. Gasgemisches an der Grenzfläche zum Bad auch ohne Trennschieber ausgebildet sein kann. Dies ist insbesondere dann der Fall, wenn das Gas bzw. Gasgemisch so ausgebildet ist, daß es Reaktionen der Atmosphäre über der Schicht mit dem Lotbad rückgängig macht. So kann die Schicht von einer Zusammensetzung aus Stickstoff und Wasserstoff gebildet sein. Diese verhindert Verunreinigungen des Bades, indem Oxidationsreaktionen des Lotes mit Luftsauerstoff dank der Anwesenheit von Wasserstoff durch entsprechende Reduktionsreaktionen rückgängig gemacht werden.

Es genügt hierbei lediglich die Anwesenheit von Wasserstoff durch Aufrechterhalten der Schicht an der Grenzfläche sicherzustellen. Dies kann durch entsprechende Ausgestaltung der Versorgungseinrichtung, beispielsweise mit entsprechenden Ausblas- und Absaugeinrichtungen, die eine stabile zirkulierende Schicht sicherstellen. Es ist nicht nötig, dass diese Schicht eine Sperrschicht bildet, so dass auch ein Sperrschieber nicht benötigt wird.

Sofern ein Spülvorgang aufgrund der Wirkungsweise einer solchen Schicht überhaupt erforderlich ist, um Verunreinigungen des Bades beim Eintauchen der Leiterplatte auszuschließen, kann auch hier eine gesonderte Spüleinrichtung für den Raum über der Schicht des ersten Gases bzw. Gasgemischs vorgesehen sein, die in der oben beschriebenen Weise arbeitet. Es kann jedoch auch die Versorgungseinrichtung so ausgebildet sein, dass sie den Spülvorgang mit übernehmen kann.

Die in Figur 1 dargestellte Vorrichtung umfasst weiterhin eine Evakuierungseinrichtung 10, die mit dem Raum 5 verbunden ist und diesen vor dem Eintauchen der Leiterplatte 3 in das Bad 2 bis zu einem gewissen ersten Evakuierungsgrad evakuieren kann. Der erste Evakuierungsgrad ist dabei so gewählt, dass er ausreicht, um die Kavitäten der Leiterplatte im ins Bad 2 eingetauchten Zustand bis zu einem Verfüllgrad mit Lot auszufüllen, bei dem störende, d. h. eine bestimmte kritische Größe überschreitende Blasen in den mit Lot gefüllten Kavitäten ausgeschlossen sind.

Das Evakuieren erfolgt im gezeigten Beispiel nach dem Spülen des zweiten Raumabschnitts 5.2 mit dem Inertgas und nach Entfernen des Sperrschiebers 6. Die Evakuierungseinrichtung 10 ist über eine Aufbereitungseinrichtung 11 mit dem Reservoir 8 verbunden, so dass zumindest ein Teil des Inertgases rückgewonnen werden kann.

Die Vorrichtung umfasst weiterhin ein Überdruckreservoir 12, welches über ein zunächst Ventil 13 mit dem Raum 5 über dem Bad 2 verbunden werden kann. Das Überdruckreservoir wird über eine Pumpeinrichtung 14 aus dem Reservoir 8 gespeist. Durch Öffnen des Ventils 13 erhöht sich der Druck im Raum 5 über dem Bad 2 und damit auch der Druck im Bad 2, dessen Pegel dabei aufgrund der vernachlässigbaren Kompressibilität der Lotschmelze im wesentlichen unverändert bleibt. Durch diese Druckerhöhung im Bad verringert sich die zum Verfüllen der Kavitäten erforderliche Eintauchtiefe und damit auch die erforderliche Verweilzeit der Leiterplatte 3 im Bad 2.

Im folgenden wird der Ablauf einer Variante des erfindungsgemäßen Verfahrens beschrieben, die mit der in Figur 1 gezeigten Vorrichtung durchgeführt wird.
Zunächst wird die Leiterplatte 3 oder eine Anzahl von Leiterplatten durch eine nicht dargestellte Zufuhreinrichtung in die geschlossene Kammer 1 eingebracht. Der Sperrschieber 6 ist dabei geschlossen. Im ersten Raumabschnitt befindet sich das durch die Versorgungseinrichtung 7 zugeführte Inertgas.

Nach dem Einbringen der Leiterplatte in die Kammer 1 wird der zweite Raumabschnitt 5.2 mittels der Spüleinrichtung mit dem Inertgas gespült. Anschließend wird der Sperrschieber 6 in Richtung des Pfeiles 6.1 entfernt. Daraufhin wird der Raum 5 mittels der Evakuierungseinrichtung 10 bis zum ersten Evakuierungsgrad evakuiert. Der Evakuierungsgrad liegt im gezeigten Beispiel im Bereich von 0,1 bar, also Vorvakuum-Bereich. Danach wird die Leiterplatte 3 in Richtung des Pfeiles 4 in das Bad 2 eingetaucht. Sobald die Leiterplatte so weit in das Bad 2 eingetaucht ist, dass sich sämtliche mit Lot zu verfüllenden Kavitäten im Bad befinden, wird das Ventil 13 zum Überdruckreservoir 12 schlagartig geöffnet. Hierdurch erhöht sich der Druck im Bad 2 schlagartig.

Der Überdruck im Überdruckreservoir 12 kann dabei so eingestellt werden, dass ein weiteres, d. h. noch tieferes Eintauchen der Leiterplatte nicht mehr erforderlich ist.

Nach der Zeit, die das Lot benötigt, um in die Kavitäten einzudringen, wird die knapp unter der Badoberfläche angeordnete Leiterplatte wieder aus dem Bad herausgezogen. Dank dieser Anordnung knapp unter der Badoberfläche ergibt sich eine sehr kurze Verweilzeit der Leiterplatte in dem Bad, da keine langen Wege im Bad zurückgelegt werden müssen.

Anschließend wird die Kammer mit Hilfe der Evakuierungseinrichtung 10 wieder auf Umgebungsdruck gebracht. Danach wird der Sperrschieber 6 wieder geschlossen und mittels der Versorgungseinrichtung 7 die Inertgasschicht wiederhergestellt. Hierbei versteht es sich, dass die Versorgungseinrichtung bei anderen Varianten auch entfallen kann, sofern die Inertgasschicht allein durch das Schließen des Sperrschiebers sichergestellt ist.

Im Anschluß daran wird die Leiterplatte 3 danach aus der Kammer 1 ausgebracht und der Zyklus kann von neuem beginnen.

Es versteht sich, dass die erfindungsgemäße Vorrichtung programmgesteuert arbeiten kann. Weiterhin versteht sich, dass das erfindungsgemäße Verfahren nicht auf die Anwendung für Leiterplatten und metallische Lotwerkstoffe beschränkt ist, sondern auf beliebige andere Bauteile mit derartigen Kavitäten im Submillimeterbereich angewandt werden kann, die in einem Bad mit einem Verfüllwerkstoff ausgefüllt werden können bzw. sollen.

Die Erfindung beschränkt sich in ihrer Ausführung nicht auf die vorstehend angegebenen bevorzugten Ausführungsbeispiele. Vielmehr isteine Anzahl von Varianten möglich, welche von der dargestellten Lösung auch bei grundsätzlich anders gearteten Ausführungen Gebrauch macht.

## Patentansprüche

1. Verfahren zum Verfüllen von im Submillimeterbereich liegenden Kavitäten in einem Bauteil (3), insbesondere einer Leiterplatte, mit einem Verfüllwerkstoff, bei dem das Bauteil (3) in ein Bad (2) des Verfüllwerkstoffs eingetaucht wird und die Kavitäten infolge des im Bad (2) bei der Eintauchtiefe vorherrschenden Drucks mit dem Verfüllwerkstoff ausgefüllt werden, dadurch gekennzeichnet, dass der im Bad (2) vorherrschende Druck zur Reduktion der zum Verfüllen der Kavitäten erforderlichen Eintauchtiefe erhöht wird

2. Verfahren nach Anspruch 1, dadurch gekennzeichnet, dass die Druckerhöhung im Bad (2) durch unmittelbare Einwirkung auf die Atmosphäre über dem Bad (2) bei im wesentlichen konstantem Pegel des Bades (2) erfolgt.

3. Verfahren nach Anspruch 2, dadurch gekennzeichnet, dass die Druckerhöhung durch Verbinden des Raumes (5) über dem Bad (2) mit einem Überdruckreservoir (12) erfolgt.

4. Verfahren nach einem der vorhergehenden Ansprüche, dadurch gekennzeichnet, dass die Druckerhöhung schlagartig erfolgt.

5. Verfahren nach einem der vorhergehenden Ansprüche, dadurch gekennzeichnet, dass zur Verhinderung von Verunreinigungen des Bades (2) an der Grenzfläche (2.1) zum Bad (2) wenigstens eine Schicht eines Gases oder Gasgemisches etabliert wird, wobei das Gas oder Gasgemisch zur Verhinderung von Verunreinigungen des Bades (2) bewirkenden Reaktionen ausgebildet ist.

6. Verfahren nach Anspruch 5, dadurch gekennzeichnet, dass die Schicht aus dem Gas oder Gasgemisch als im wesentlichen inerte Sperrschicht ausgebildet ist.

7. Verfahren nach Anspruch 5, dadurch gekennzeichnet, dass die Schicht aus dem Gas oder Gasgemisch derart ausgebildet ist, dass sich Verunreinigungen des Bades (2) bewirkende erste Reaktionen und diese ersten Reaktionen rückgängig machende zweite Reaktionen, insbesondere Oxidation und Reduktion, im wesentlichen die Waage halten.

8. Verfahren nach Anspruch 7, dadurch gekennzeichnet, dass das Gas oder Gasgemisch einen für die Reduktion ausreichenden Anteil Wasserstoff enthält.

9. Verfahren nach einem der Ansprüche 5 bis 8, dadurch gekennzeichnet, dass der Raum (5, 5.2) über dem Bad (2) in einem Spülschritt vor dem Eintauchen des Bauteils (3) in das Bad (2) mit dem Gas oder Gasgemisch gespült wird.

10. Verfahren nach einem der Ansprüche 5 bis 9, dadurch gekennzeichnet, dass die Schicht aus dem Gas oder Gasgemisch vom übrigen Raum (5.2) über dem Bad (2) vor dem Eintauchen des Bauteils (3) durch eine Trenneinrichtung (6) abgetrennt ist.

11. Verfahren zum Verfüllen von im Submillimeterbereich liegenden Kavitäten in einem Bauteil (3), insbesondere einer Leiterplatte, mit einem Verfüllwerkstoff, insbesondere nach einem der vorhergehenden Ansprüche, bei dem das Bauteil (3) in ein Bad (2) des Verfüllwerkstoffs eingetaucht wird und die Kavitäten infolge des im Bad (2) bei der Eintauchtiefe vorherrschenden Drucks mit dem Verfüllwerkstoff ausgefüllt werden, dadurch gekennzeichnet, dass der das Bauteil (3) vor dem Eintauchen in das Bad (2) umgebende Raum (5) vor dem Eintauchen wenigstens bis zu einem Evakuierungsgrad evakuiert wird, der ausreicht, um die Kavitäten des Bauteils (3) im eingetauchten Zustand bis zu einem Verfüllgrad zu verfüllen, der störende Blasen in den mit Verfüllwerkstoff ausgefüllten Kavitäten im wesentlichen ausschließt.

12. Verfahren nach Anspruch 11, dadurch gekennzeichnet, dass der Grad der Evakuierung im Vorvakuum-Bereich liegt, insbesondere im Bereich von 0,1 bar.

13. Vorrichtung zum Verfüllen von im Submillimeterbereich liegenden Kavitäten in einem Bauteil (3), insbesondere einer Leiterplatte, mit einem Verfüllwerkstoff, umfassend ein Bad (2) des Verfüllwerkstoffs zum Verfüllen der Kavitäten mit dem Verfüllwerkstoff durch Eintauchen des Bauteils (3) in das Bad (2), dadurch gekennzeichnet, dass zur Reduktion der zum Verfüllen der Kavitäten erforderlichen Eintauchtiefe des Bauteils (3) eine Druckerhöhungseinrichtung (12, 13, 14) zum Erhöhen des im Bad (2) vorherrschenden Drucks vorgesehen ist.

14. Vorrichtung nach Anspruch 13, dadurch gekennzeichnet, dass die Druckerhöhungseinrichtung (12, 13, 14) zum Erhöhen des Drucks im Raum (5) über dem Bad (2) bei im wesentlichen konstanten Pegel des Bades (2) ausgebildet ist.

15. Vorrichtung nach Anspruch 14, dadurch gekennzeichnet, dass die Druckerhöhungseinrichtung ein mit dem Raum (5) über dem Bad (2) verbindbares Überdruckreservoir (12) umfasst.

16. Vorrichtung nach einem der Ansprüche 13 bis 15, dadurch gekennzeichnet, dass eine erste Einrichtung (6, 7) zum Etablieren wenigstens einer ersten Schicht eines ersten Gases oder Gasgemisches an der Grenzfläche (2.1) zum Bad (2) vorgesehen ist.

17. Vorrichtung nach Anspruch 16, dadurch gekennzeichnet, dass die erste Einrichtung (6, 7) eine Trenneinrichtung (6) zum Abtrennen des von der Schicht des ersten Gases oder Gasgemischs eingenommenen Raums (5.1) von dem übrigen Raum (5.2) über dem Bad umfaßt.

18. Vorrichtung nach Anspruch 17, dadurch gekennzeichnet, dass die Trenneinrichtung von wenigstens einem Sperrschieber (6) gebildet ist.

19. Vorrichtung nach einem der Ansprüche 16 bis 18, dadurch gekennzeichnet, dass eine zweite Einrichtung (9) zum Spülen des Raumes (5.2) über der Schicht des ersten Gases oder Gasgemischs mit dem ersten Gas oder Gasgemisch vorgesehen ist.

20. Vorrichtung nach einem der Ansprüche 13 bis 19, dadurch gekennzeichnet, dass zum Evakuieren des das Bauteil (3) vor dem Eintauchen in das Bad (2) umgebenden Raums (5) vor dem Eintauchen wenigstens bis zu einem ersten Evakuierungsgrad eine Evakuierungseinrichtung (10) vorgesehen ist, wobei der erste Evakuierungsgrad ausreicht, um die Kavitäten des Bauteils (3) im eingetauchten Zustand bis zu einem Verfüllgrad zu verfüllen, der störende Blasen in den mit Verfüllwerkstoff ausgefüllten Kavitäten im wesentlichen ausschließt.

21. Vorrichtung nach Anspruch 20, dadurch gekennzeichnet, dass die Evakuierungseinrichtung (10) wenigstens zum Erzielen eines Evakuierungsgrads im Vorvakuum-Bereich, insbesondere im Bereich von 0,1 bar, ausgebildet ist.
